(19)

Europäisches
Patentamt
European
Patent Office
Office européen
des brevets

(11)  **EP 2 469 714 A1**

(12)  **EUROPEAN PATENT APPLICATION**

(43) Date of publication:
**27.06.2012 Bulletin 2012/26**

(51) Int Cl.:
*H03L 7/087* [(2006.01)]   *H03L 7/091* [(2006.01)]
*H03L 7/099* [(2006.01)]

(21) Application number: **11193713.2**

(22) Date of filing: **15.12.2011**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **17.12.2010 EP 10195747**

(71) Applicant: **NXP B.V.**
**5656 AG Eindhoven (NL)**

(72) Inventors:
• **Van der Wel, Arnoud**
  **5656 AG Eindhoven (NL)**
• **Den Besten, Gerrit Willem**
  **5656 AG Eindhoven (NL)**

(74) Representative: **Schouten, Marcus Maria**
  **NXP B.V.**
  **Intellectual Property & Licensing Department**
  **High Tech Campus 32**
  **5656 AG  Eindhoven (NL)**

(54)  **Multi phase clock and data recovery system**

(57)    The invention describes a multi-phase clock and data recovery circuit system comprising a voltage controlled oscillator including a plurality of identical structural cells coupled in a ring, the voltage controlled oscillator providing a first plurality of phased shifted signals having the same frequency. The circuit further comprises a feedback loop including a second plurality of data samplers adapted to receive the first plurality of phase shifted signals provided by the voltage controlled oscillator and a phase detector coupled to coupled to a phase alignment circuit receiving output signals generated by the second plurality of data samplers and generating control signals to the voltage controlled oscillator at a bit rate of the input signal.

FIG. 3

## Description

FIELD OF THE INVENTION

The invention relates to a multi phase clock and data recovery system.

BACKGROUND OF THE INVENTION

For very high-speed serial data transmission typically embedded clock signaling is applied, where the transmitter utilizes a certain encoding scheme to include sufficient clock information in the serialized data stream to allow the receiving side to retrieve the originally transmitted data by means of Clock and Data Recovery (CDR) and a complementary decoder. Coding schemes may additionally provide signal conditioning like for example dc-balancing and/or spectral shaping. An often applied coding scheme is 8B10B, where every data byte translates into a 10-bit symbol, and that also provides control symbols, some of them including unique sequences to unambiguously determine the symbol boundaries.

The Clock and Data Recovery (CDR) function in the receiving path can be accomplished by a synchronous solution utilizing a data- tracking PLL that is feedback-controlled to sample the center of the bits, or by an over-sampled solution which samples the input signal more than twice per bit period with a clock derived from a reference clock followed by a digital data & clock recovery algorithm.

Although over-sampled solutions have some benefits, a major disadvantage is that these required more circuit speed in the implementation and therefore typically also consume more power. This is especially critical if an implementation targets the maximum achievable speed in a certain semi-conductor process.

For synchronous data-tracking PLLs the double-sampled architecture (half-bit spaced alternating center and edge samples) with early-late phase-detection (also called bang-bang phase detection) is often utilized as this provides intrinsically good phase alignment, due to the fact that the clock and the data recovery functions utilize the same samplers and have matched signals paths.

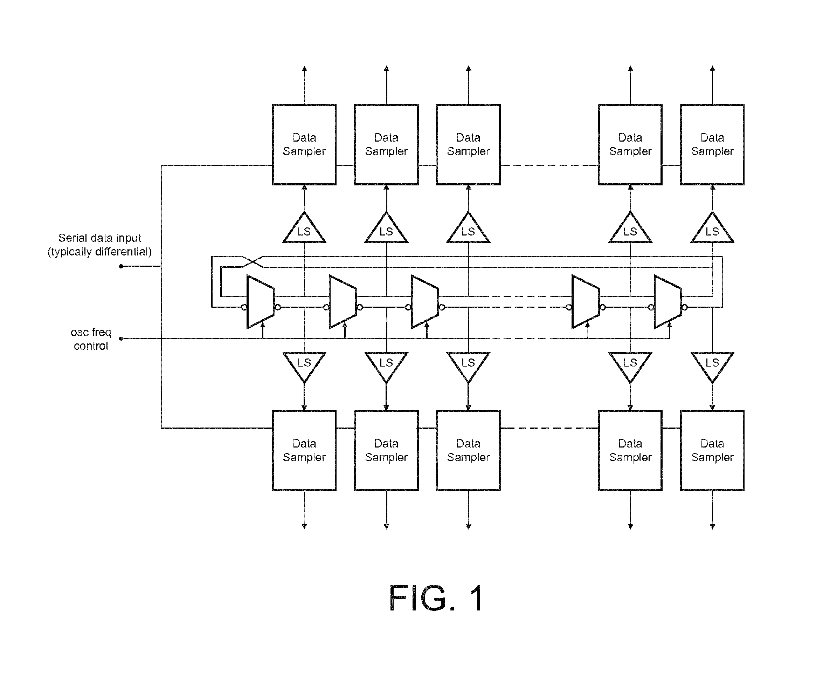

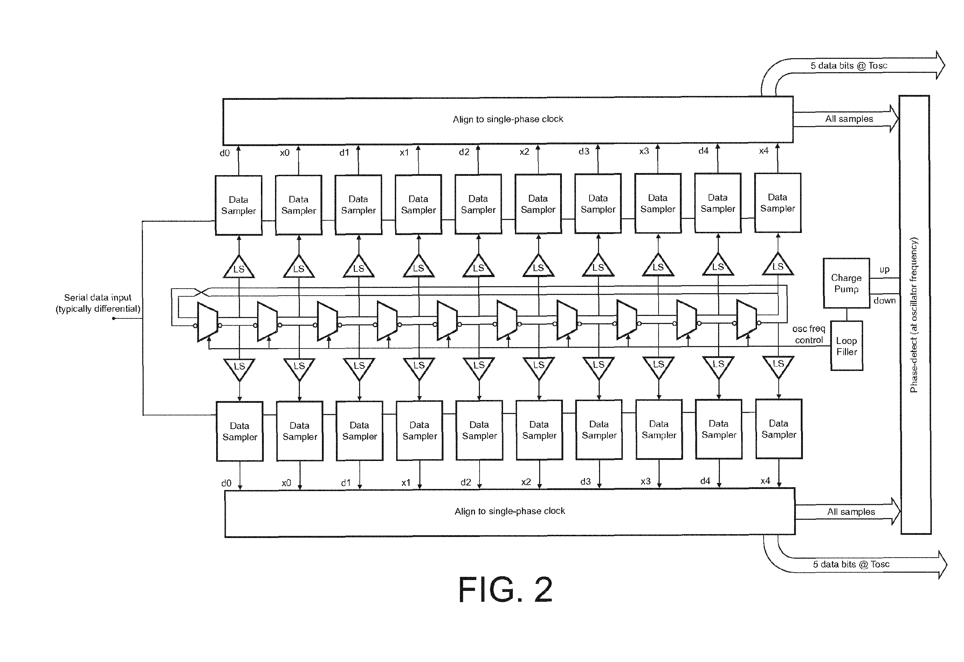

In order to achieve very high data rates in a technology with limited circuit speed, it is beneficial to apply parallelism by means of multi-phase oscillators and distributed interleaved samplers, as shown in figure 1: A multi-phase oscillator generates multiple clock-phases, typically homogeneously distributed over the oscillator period, which after level-shifting (LS) do clock the data samplers. This reduces the required oscillator frequency and therefore increases the clock period thereby allowing more time for each sampler to make a decision. An example of how the control loop typically works is shown in figure 2 for a 20-phase oscillator. As each sampler is clocked by a different clock phase, the sampler results are re-aligned to a single clock phase before these are fed to the digital phase-detector operated at the oscillator clock frequency. The phase-detector decision is fed to a Charge-Pump which corrects the frequency of the oscillator via a Loop-Filter. However, this implies that the update frequency of phase-detection feedback decreases with increased parallelism. This reduction of the feedback control frequency reduces the maximum achievable tracking bandwidth.

SUMMARY OF THE INVENTION

It is therefore an object of the invention to improve the speed of the data acquisition and correction of a clock and data recovery circuit.

This object is achieved in a multi-phase clock and data recovery circuit system comprising:

- a voltage controlled oscillator including a plurality of identical structural cells coupled in a ring, the voltage controlled oscillator providing a first plurality of phased shifted signals having the same frequency;
- a feedback loop including:
- a second plurality of data samplers adapted to receive the first plurality of phase shifted signals provided by the voltage controlled oscillator; and
- a phase detector coupled to coupled to a phase alignment circuit receiving output signals generated by the second plurality of data samplers and generating control signals to the voltage controlled oscillator at a bit rate of the input signal.

In an embodiment of the invention the multi-phase clock and data recovery circuit system the first plurality of phase shifted signals comprises a first set of signals and a second set of signals, coupled in pairs, each signal of the first set having a corresponded quadrature signal in the second set. In the multi-phase clock and data recovery circuit system each signal of the first set signals and the second set of signals are inputted to a respective third set of data samplers and a fourth set of data samplers.

Preferably, in the multi-phase clock and data recovery circuit system, the data samplers comprise one hot data samplers. The one hot data samplers advantageously comprise T latches or T flip-flops generating T-aligned signals. In the data and clock recovery circuit according to the present invention, the phase detector receives a combination of the T-aligned signals.

The invention is defined by the independent claims. Dependent claims define advantageous embodiments.

BRIEF DESCRIPTION OF THE DRAWINGS

The above and other advantages will be apparent from the exemplary description of the accompanying drawings in which

Fig.1 depicts a multi-phase architecture concept, according to the invention;

Fig.2 depicts a 20-phase architecture including phase-control feedback loop;

Fig.3 depicts a 20-phase architecture using fractional-T samplers and excluding phase-control feedback loop;

Fig.4 depicts a 20-phase architecture using fractional-T samplers, including bitwise feedback phase-control;

Fig.5 depicts bitwise edge-detector logic functions and implementations;

Fig.6 depicts a Fractional-T sampler with one-hot outputs;

Fig. 7 depicts a single clock-phase fractional-T sampler with one-hot outputs;

Fig.8 depicts a full-T generation and phase-alignment of sampler results to digital synchronous output;

Fig.9: depicts an example of timing of clock-phases, sampler outputs, and edge-detector outputs;

Fig,10 depicts an example of timing of clock-phases, sampler outputs, and edge-detector outputs in case of delayed decision of the edge sampler;

Fig.11 depicts an example of a charge-pump implementation;

Fig.12 depicts an example of timing of clock-phases, sampler outputs, and OR' ed edge-detector output of opposite phase clocked samplers; and

Fig.13 depicts an example of Level-Shifter (LS) implementation.

## DETAILED DESCRIPTION OF EMBODIMENTS

This present invention describes a distributed interleaved phase-detectors in a multi-phase CDR architecture operated directly at the phase-skewed sampler outputs in order to obtain phase-detection feedback at the bit rate, thereby allowing improved tracking bandwidth. The phase alignment between samples will typically still be applied to provide the desired set of samples as a data word on a single-phase clock at its outputs towards the next function in the receive path, but this phase-alignment is not part of the phase-tracking feedback loop anymore. Furthermore this invention enables the application of distributed interleaved charge-pumps for improved control linearity.

The present invention describes a solution for bit-wise phase detection and bitrate phase-feedback in a multi-phase architecture operated with two samples per bit, using sets of three consecutive samples, each set including the last taken sample of the previous set and the next two samples, wherein phase detection is performed on each individual set when all sample results in that set are available, and wherein based on these phase detector decisions frequency control feedback is provided at the bit rate.

It is part of this invention to apply samplers which output can indicate one of three possible states: a decision that the input was representing a logical "0" at the sampling moment, a decision that the input was representing a logical "1" at the sampling moment, or no decision because the sampler is either in its reset phase or is already sampling but has not reached a decision yet.

The referred type of sampler will be denoted as fractional-T sampler because it provides information about the sampling decision only for a fraction of the total oscillator period. In order to generate full-T pulses from such a sampler output, an additional full-T generating latch or flip-flop can be applied behind it, but these additional full-T generating latches or flip-flips are not part of the phase control feedback loop.

It is also part of the invention to apply samplers with two separate one-hot logical outputs to indicate a "0" or "1" decision, while none of these two outputs is asserted during the reset phase and as long as there is no decision during the sampling phase.

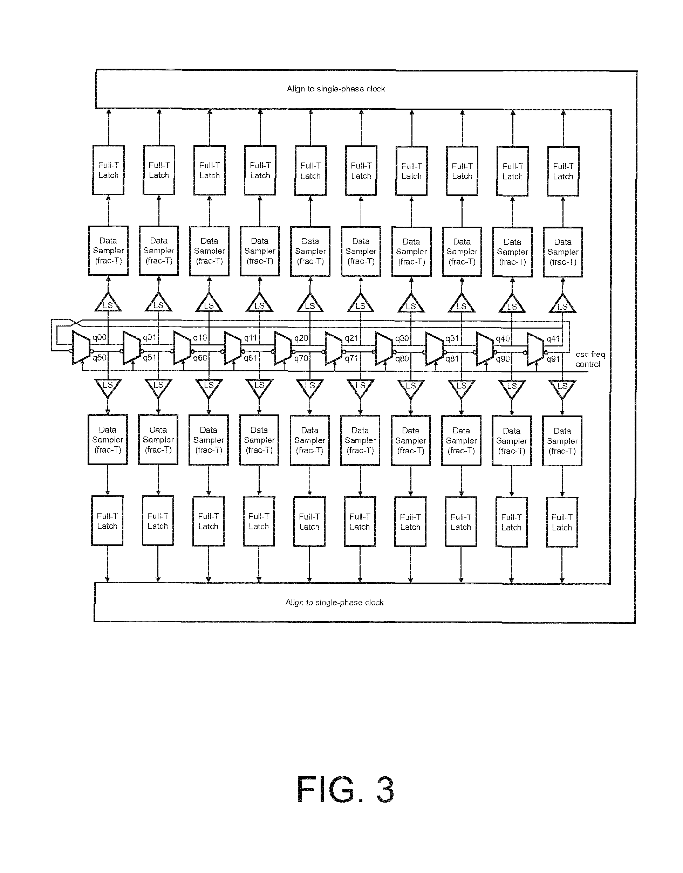

A multi-phase architecture example for 20-phases, using fractional-T samplers, is shown in Fig. 3. The sampler outputs, named s## may each indicate one - of - three possible states. These outputs are used for the edge-detection that feeds the phase-control feedback loop. This part is not shown in this drawing but will be dealt with in the next one. The full-T latches or flip-flops bring the sampler results in full-T format to the phase-alignment block, where they are typically aligned to a single-phase clock in order to be convenient for FIFOs and further digital processing. The full-T samples are indicated by alternating d# and x#, which d# corresponds to data center samples and x# to the data-crossing samples (if there is a transition between two bits). Which samples in the architecture are defined to be d# and which are x# is arbitrary, and depends on how the phase-feedback circuitry is implemented. A synchronous data-tracking multi-phase CDR will typically be operated using two samples per bit period to support the highest data rate, in which case consecutive samples will be alternating bit center and bit edge samples. For convenience it is chosen in the drawings to have d0 at the top-left. The numbering of the sampler outputs s## is chosen such that the first digit (#) indicates the bit number in the multi-phase architecture and the second digit indicates whether this is a center sample (0) or the following edge sample (1).

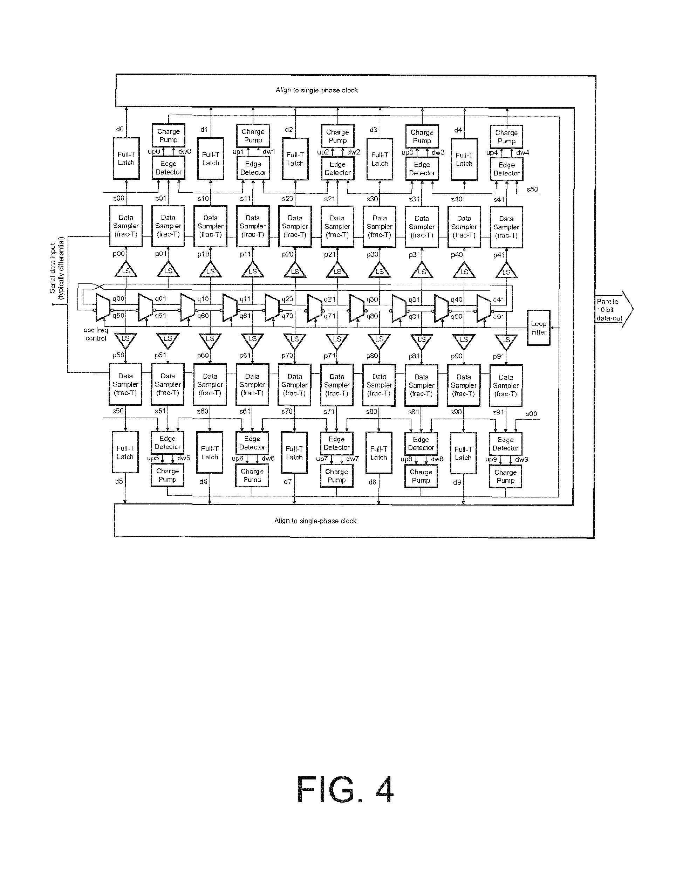

Fig.4 shows an example of a 20-phase architecture, including bitwise phase-control feedback. The full-T generating latches or flip-flops for the x# samples, which are shown in Fig. 3 are no longer shown in Fig. 4 for clarity purposes and because they are not necessary for clock and data recovery anymore in the solution according to this invention. Of course these x# samples may for example still be useful for diagnostic purposes and can be additionally aligned and provided at the output.

Each edge detector monitors three consecutively clocked sampler outputs. The middle of those three samples will become an edge sample and the two surrounding samples therefore data samples. Each edge-detector indicates whether the frequency needs to be increased, decreased or shouldn't change. These correction pulses are fed into charge-pumps, which inject current into or subtract a current from their outputs when they receive an up or down pulse on their inputs. The charge-pump outputs are summed into the loop-filter to adapt the oscillator frequency, thereby also correcting the phases. Fig.4 shows a 20-phase architecture example, covering 10 bits in parallel, therefore including 10 edge-detectors; one per bit. In this figure, 10 separate charge-pumps each driven by one edge-detector, are shown. This is a simple way to close the feedback loop independently per bit. Alternatively the edge-detector outputs could be converted into multi-bit up and down correction codes, updated at the bit rate, which are fed into a single charge-pump with a multi-level output current that is set by the multi-level up and down control words. A third option is to reduce the number of charge-pumps by merging non-overlapping edge-detector outputs.

Let us consider first the edge-detector logic function, not looking at timing aspects immediately. For comprehensibility of the logic functions, this will be done as if the edge-detectors are operated on forever-present data (di) and edge (xi) sample results. It should be kept in mind that this is only done for comprehensibility, as for an implementation according to this invention the edge-detectors hook-up to the fractional-T sampler outputs, whose results are not forever present. After explanation of the logic functions, the fractional-T sampler will be described in more detail, and finally the edge-detector timing aspects and the actual hook-up of the edge-detectors to the fractional-T samplers will be discussed in more detail.

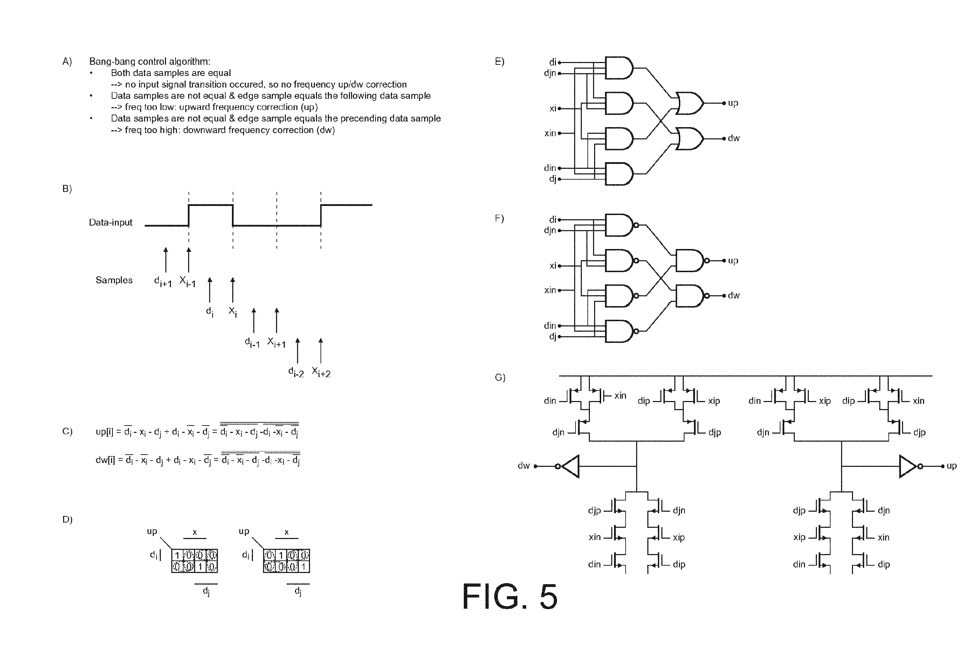

Fig.5 shows several aspects of the edge-detector in figures 5a) through 5g). Figure 5a lists the functional requirements of a logical bang-bang phase-detector function as is going to be used for the edge-detectors. Fig.5b illustrates the positioning of data center and edge samples with respect to the serial input data stream when the loop is settled. In fig.5c the logic functions are given, which correspond to the requirements of Fig. 5a. In Fig. 5d the Karnaugh diagrams are shown for the logic functions of up and dw. Example embodiments of the edge-detector logic functions are shown in figures 5e-5g, where the following mapping toward input signals is applied:

$$d_i = dip$$

$$\overline{d_i} = din$$

$$x_i = xip$$

$$\overline{x_i} = xin$$

$$d_j = djp$$

$$\overline{d_j} = djn$$

Fig. 5f shows an embodiment which is a straightforward implementation of the terms in both logic functions. Fig.5g shows a NAND-only embodiment, which can be beneficial for speed reasons. Fig.5h shows a custom logic cell implementation, where the 3 stacked NMOS transistors branches correspond with the basic terms in the logic functions, while the PMOS side realizes the inverse of that, which is also indicated by dotted ovals in the Karnaugh diagrams of Fig.5e.

These are only a few possible example embodiments to implement the desired logic functions, but several alternatives are possible.

Note that in the explanation of the edge-detector it is implicitly assumed that the up and dw correction pulses are indicated by a logic one while no correction corresponds with logic zero. This is an arbitrary choice and could be chosen inverse for either up, dw or both.

Note that embodiment of the edge-detectors in actual practical designs may includes additionally an enabling signal to disable parts of the design when these are not needed.

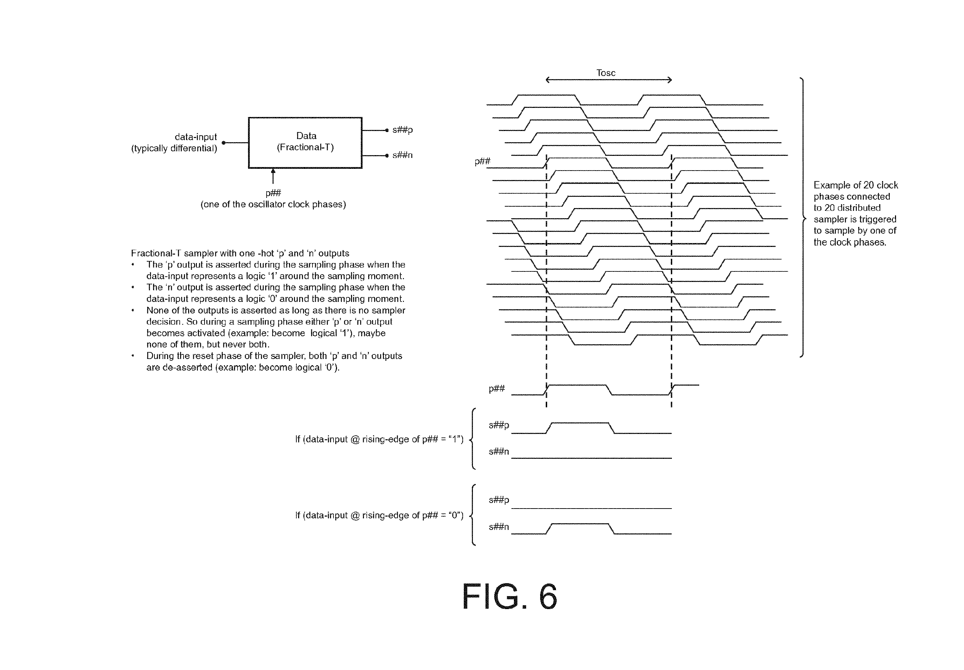

Fig.6 shows an example of a fractional-T sampler. A fractional-T sampler receives a serial data stream at its input. The input signal will typically be differential, swig limited, for very high speed applications.

Furthermore, the fractional-T sampler receives at least one clock phase to sample the data, where one edge triggers the sampling, while the other edge initiates the reset of the sampler to get ready for the next sampling with little or no impact from previous decisions. In the examples it is chosen that the rising edge triggers the sampling and a falling edge starting the reset for comprehensibility reasons, but note that this can also be chosen oppositely.

For routing reasons, it is attractive to have each sampler operated from a single clock phase. In that case the sampling and reset phase will each roughly take half of the oscillator period. Note that multiple clock phases can be used for each sampler to modify the ratio between sampling and reset phase, at the cost of some extra clock-phase routing complexity.

Fractional-T samplers make a decision during the sampling phase about the logic value represented by their input signal during the input sensitivity time-window and provide that decision to their outputs. The input sensitivity window is the time around the sampling triggering edge during which the decision is determined, although the decision may become available later at the output due to the time required for regeneration to a logic value. In order to distinguish a logic one and logic zero and no decision or reset from each other, at least three states are needed. A simple and convenient way to accomplish that is with 2 logic one-hot outputs, here denoted by postfixes 'p' and 'n', that indicate a logic one when the 'p' output is asserted, a logic zero if the 'n' output is asserted and no decision or reset phase if none of them is asserted. Fig.6 also illustrates the timing of clock phase for a 20-phase example, where each sampler is connected to one of the clock phases. During the sampling phase either the 'p' or the 'n' output is asserted while both outputs are low during reset and during sampling as long as the decision has not been made yet. Note that assertion is represented by becoming a logic one in the example timing figure according to positive logic; nevertheless a complementary choice is possible too.

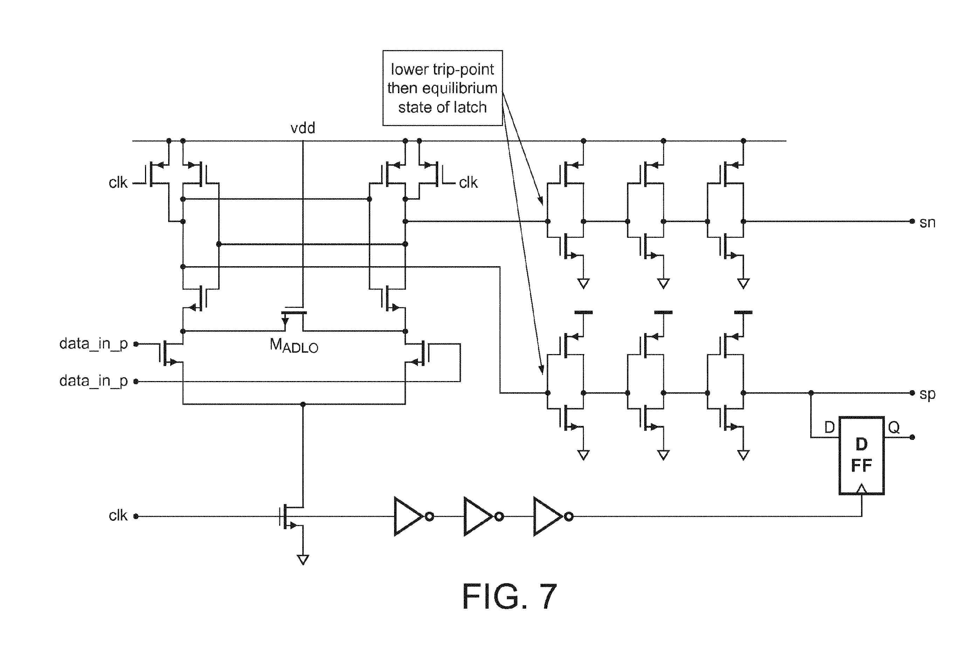

Fig.7 shows an example embodiment of a single clock-phase sampler with one-hot outputs. Note that the optional device indicated by $M_{ADLO}$ provides Automatic input Data Lock-Out by shorting the outputs of the input differential pair, to constrain the input sensitivity window. On the sampling clock-edge, the regenerative latch outputs start at the supply voltage level vdd and decrease while the differential pair currents are integrated in the latch, until a decision is made and regenerated to full logic levels by positive feedback in the latch. The latch outputs are read-out by inverters, whose threshold can best be positioned below the equilibrium voltage of the latch, so that these inverters won't toggle as long as no decision has been made. When the decision is made one of the two outputs will go low and one goes back to vdd level, so that only one of the inverter outputs will change. After this first inverter one or more extra inverter-based buffers may be needed to get sufficient drive to the output. In this example implementation there are two extra inverters shown in each path.

This figure shows an embodiment with NMOS input pair which is particularly suitable for input signals with a high common-mode level. Obviously, a complementary version having a PMOS input pair can be applied instead for low common-mode input levels.

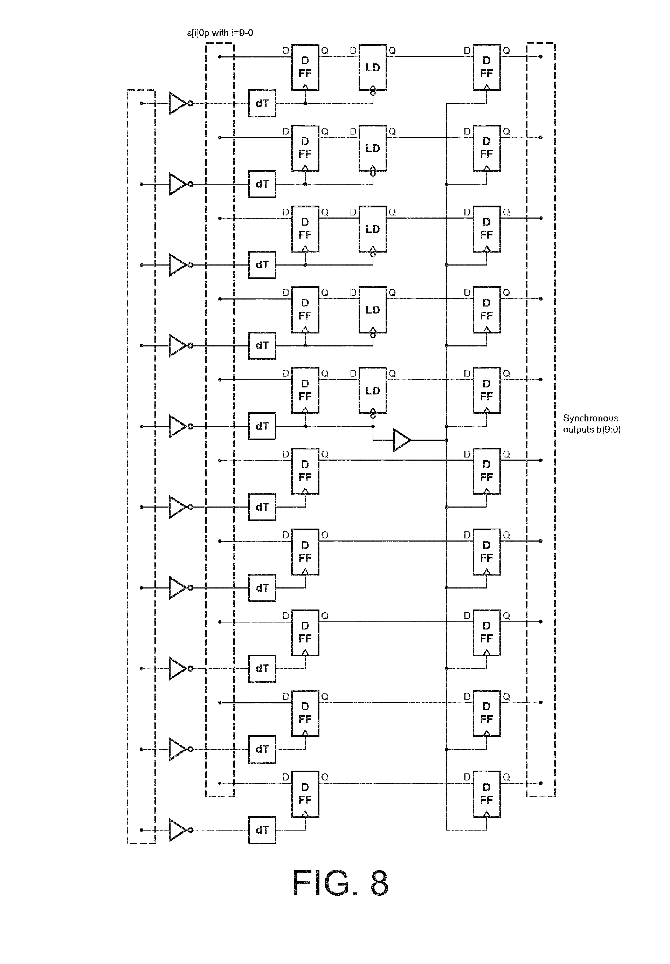

Figure 7 additionally shows an example of how the sampler results can be converted to full-T pulses by applying a flip-flop that is clocked by a delayed clock signal with respect to the sampler input clock, which captures the sampling result, just before the samplers outputs s##p and s##n are de-asserted again in the reset phase. The full-T sampling results can then for example be phase-aligned by the well-known method to delay sets of samples by fractions of the clock period by means of latches in order to create a period where all full-T sampler results are stable, and finally taking all samples into a register on a single clock phase. A frequently used variant of that uses two sets of samples, each including half the samples, where the first set includes the samples taken first and the second set includes the samples which are taken after the first set. The samples of the first set are delayed by half a clock period by adding an extra latch in these paths. An example embodiment for 10 bits is shown in figure 8. Note the first flip-flop and the inverters and delays in the clock path for each bit were also shown in the example embodiment of the sampler in figure 7.

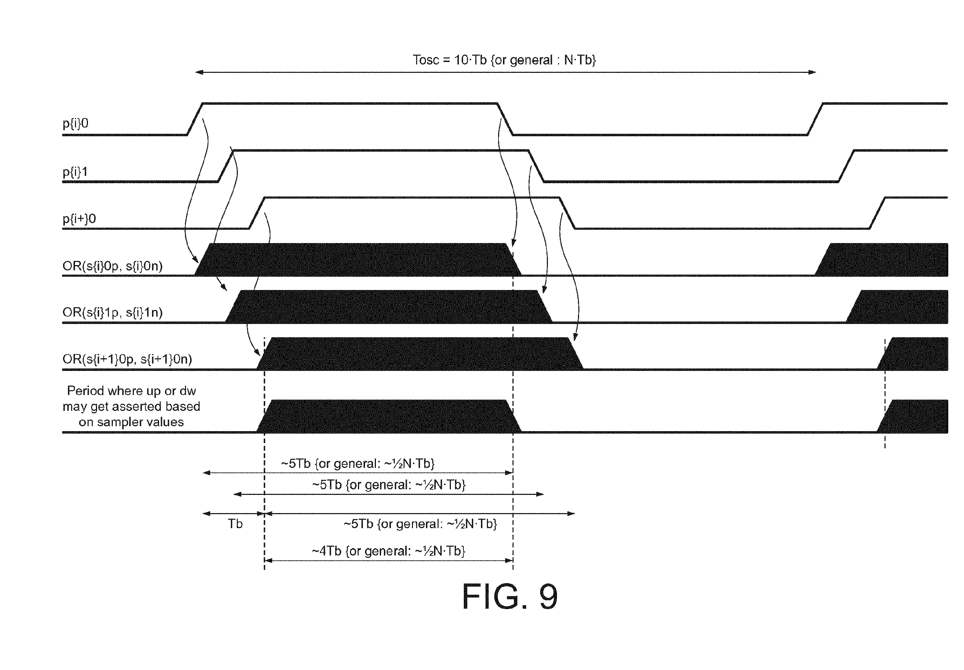

Figure 9 shows an example of the timing of the clocks and signals related to one of the edge-detectors in a 20-phase architecture. The three samplers providing the input signals for one edge-detector are clocked by three consecutive clock phases, denoted by p{i}0, p{i}1, and p{i+1}0. Therefore the outputs of the sampler will be skewed in time compared to each other, both due to the skews between driving clocks as well as due to differences in sampler decision time; the latter also being impacted by the momentary data input signal values. First we consider the situation when the decision time is short with respect to the sampling period and has a similar value for all samplers. For each sampler only one of the two one-hot outputs will be asserted when a decision is made, and never both. Combining both sampler outputs virtually by an OR function results in a virtual signal that becomes asserted during the sampling phase when the decision is available and is not-asserted during reset phase and during the sampling phase as long as the decision has not been reached yet. This is shown in figure 9 for the three samplers associated with one edge-detector. Now the edge-detector is not fed by the logic sampled input data and their inverse as input signals, but by the one-hot sampler outputs instead according to the following mapping:

$$dip = s[i]0p$$

$$din = s[i]0n$$

$$xip = s[i]1p$$

$$xin = s[i]1n$$

$$djp = s[i+1]0p$$

$$djn = s[i+1]0n$$

The one-hot sampler outputs provide a windowing function, as that the edge-detector can only generate up or dw pulses during the periods that all three samplers have reached a decision and the logic functions like discussed before become true. The three samples for one edge-detector are nominally skewed by half a bit each, resulting in a one bit period skew between the first and the third sample. For a 20-phase architecture, this results in up or dw correction pulse lengths of about 4 bits or less. In general for a 2N-phase architecture, the up or dw correction pulse duration will be about (N-1) bits or less.

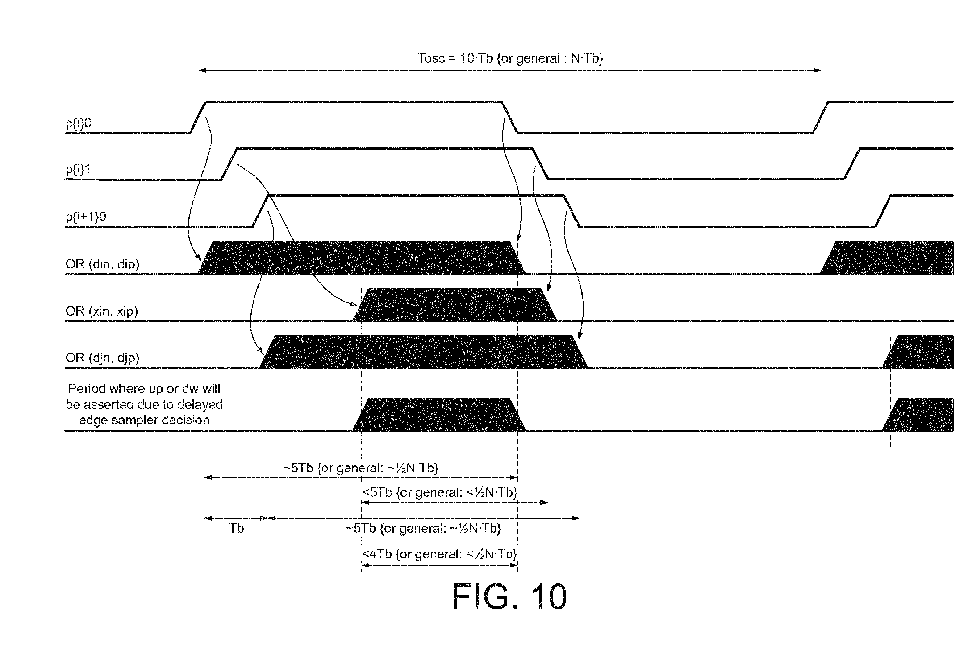

The fact that the up or dw pulse can become shorter is illustrated by an example in figure 10. If one of the involved samplers has difficulty to make a decision, none of the one-hot outputs of that sampler will be asserted until a decision is reached. While waiting for this decision, the edge-detector will not generate an up or dw pulse.

Note that if there is no transition the samplers will reach a decision, but still no up or dw pulse will be generated as the logic functions will not become true.

The behavior of samplers and edge-detectors can therefore be summarized as follows:

- Each sampler goes through two phases during a full oscillator period: a sampling and reset phase
- All samplers provide their outputs shifted in time, due to the distributed clock phases.
- Results of three consecutively clocked samplers are needed for each edge-detector: two data samples ( s{i}0 and s{i+1}0) and one edge sample ( s{i}1 ), the latter taken in between these two data samples.
- The behaviour of an edge-detector throughout an oscillator period can be sub-divided in three phases regarding its input signal states:

    1. All three involved samplers are in sampling phase and have made a decision, resulting in three possible cases:

        o Both data samples are equal

            → no input signal transition occurred, so no frequency up/dw correction

        o Data samples are not equal & edge sample equals the following data sample

            → freq too low: upward frequency correction (up)

        o Data samples are not equal & edge sample equals the preceding data sample

            → freq too high: downward frequency correction (dw)

    2. At least one of the three samplers is in its reset phase with de-asserted 'p' and 'n' outputs, so therefore no up/dw frequency correction
    3. All three involved samplers are sampling but at least one of them has not reached a decision yet, so neither its 'p' nor 'n' output is asserted: no up/dw frequency correction

- The logic functions for the up and dw signals according to 1) can be implemented such that when both outputs of a sampler are de-asserted of at least one of the three involved samplers , the up/dw signals will be de-asserted, thereby also covering 2) and 3)

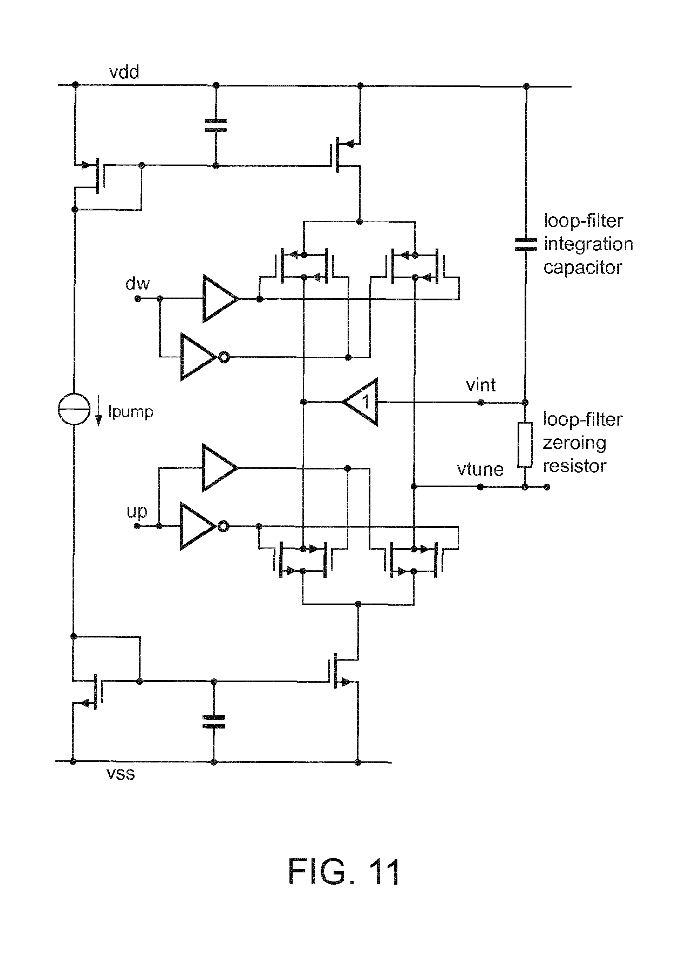

The edge detector up and dw outputs drive charge-pumps to pump a current in or out of a loop-filter. An example of a charge-pump and loop-filter implementation containing a pole and a zero, is shown in figure 11. In this example the output voltage of the loop filter, being the oscillator frequency control voltage, is with respect to Vdd as is often preferable in practical oscillator implementations for good PSRR. The loop-filter can also be implemented with respect to Vss if that is preferred for oscillator control, but it should be noted that up and dw inputs have to be swapped in that case too.

Note that the loop-filter is shared for all charge-pumps. Furthermore, the bias generation and unity gain buffer for the dummy paths can potentially be shared for all charge-pumps.

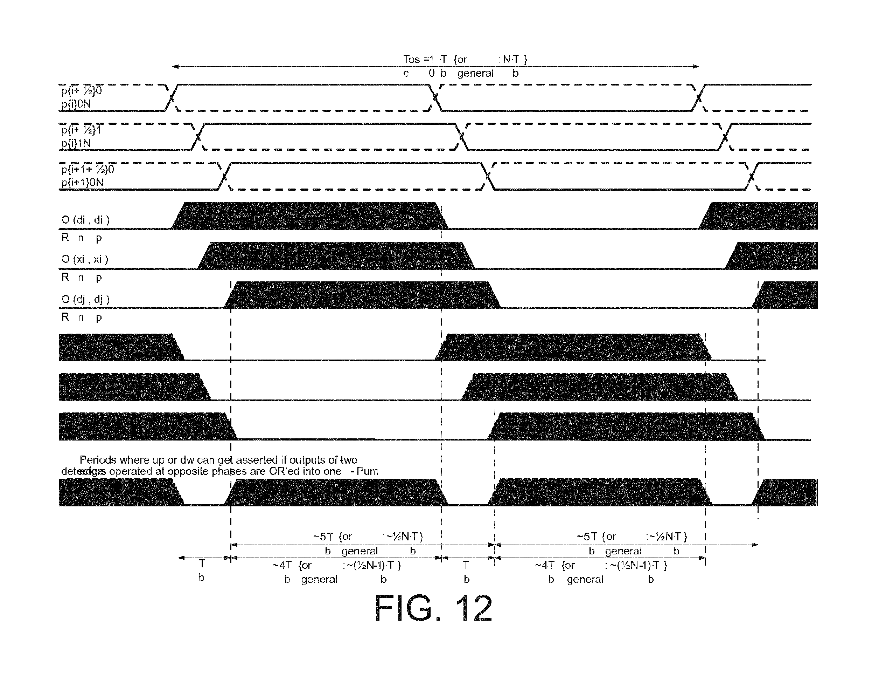

In order to reduce the number of charge-pumps the up and dw pulse of the two edge-detector driven by samplers with opposite phase clocks can be combined with an OR function as they never overlap. This is illustrated in figure 12. Note that the off-time period of the charge-pump(s) may become short in that case.

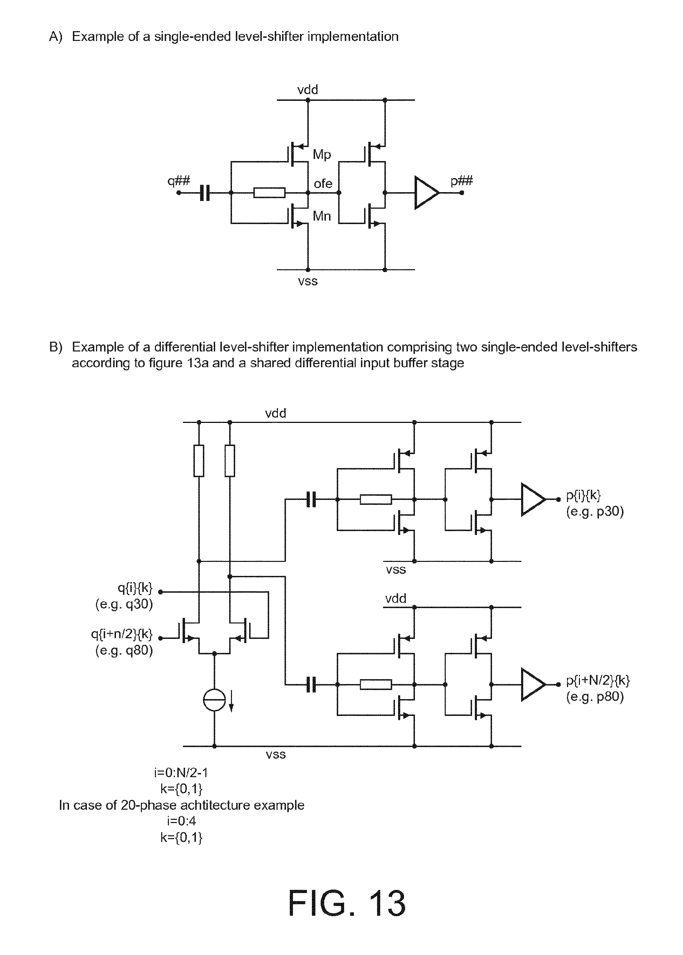

Figure 13 shows example embodiments for the level-shifters that deliver the clock phases to the samplers. The function of level-shifters is to adapt signal levels of the oscillator core to the signal levels required to drive the samplers.

Figure 13a shows a possible embodiment of a level-shifter, which can be used in case of low-swing oscillator signals and logical output clock signal levels are desirable. The inputs of level-shifters are coupled to the different phases in the oscillator core. There are 2N single-ended level-shifters needed to cover all phases of a 2N-phase architecture.

The delay of a level-shifter, defined as the delay between the input signal transition that initiates the sampling-triggering output edge and the actual output transition being the sampling-triggering event, should show little variation, as several instantiations of the level-shifter operate in parallel (see figures 1-4), and variations in level-shifter delay cause non-uniformly time-distributed sampling events, which will degrade CDR performance. Variation in level-shifter delay is caused by mismatch between nominally identical components in different instantiations of in the level-shifter, and in particular for the devices Mn and Mp in figure 13a. Matching can be improved by increasing device sizes, but this also increases input capacitance of the level-shifter, which increases power consumption in the oscillator and/or decreases its maximum operating frequency.

In CMOS inverter implementations, typically, the PMOS device has a larger W/L than the NMOS device in order to balance drive-strengths of both devices. However, for level-shifter performance, it can be beneficial to make the NMOS device Mn stronger than the PMOS device Mp, by increasing the size of Mn and decreasing the size of Mp, while keeping the input capacitance constant. This leads to a certain optimum, where the W/L of the NMOS Mn device may become even larger than the W/L of the PMOS device Mp. This optimization reduces timing variation of the falling edge at node 'ofe' . Furthermore this optimization causes the level-shifter output duty cycle to deviate from 50%, which can be advantageously used to lengthen the 'sampling' phase of the samplers at the expense of the 'reset' phase. A side effect of this optimization is that the rising edge on node 'ofe' will show increased variation, which doesn't have to be a limiting factor as a CDR can be implemented such that its relies on the accuracy of one clock edge type only. Between node 'ofe' with a timing-optimized falling edge, and a data sampler, an odd number of inverters should be inserted if the data sampler samples the input data on a rising clock edge. Otherwise, if the data sampler samples the input data on a falling clock edge an even number of inverters should be inserted there.

Figure 13b shows an example of a level-shifter embodiment with differential input, consisting of a differential buffer stage followed by two single-ended structures which are each similar to figure 8a. If differential level-shifters are applied, the two inputs of each differential level-shifter couple to opposite phases in the oscillator core, while each differential level-shifter provides two output clock-phases. This implies that N differential level-shifters are needed to cover all clock phases in a 2N-phase architecture.

Next to the previously described set of edge-detectors, optionally, an additional set of edge-detectors may be applied, driven by an equidistantly phase-spaced sub-set of all samplers. Connection of this extra set of edge-detectors to the sub-set of used samplers is similar to the case when only that sub-set of samplers would have been present. For example, for the 20-phase oscillator, this can be accomplished by only using every other sampler and ignoring the samplers in between. This allows disabling the set of not-used samplers. Connection of the additional set of edge detectors is similar to if only these 10 samplers would have been present, so equivalent to a 10-phase oscillator architecture. Note that the position of center and/or edge samples will change compared to the case using all 20-phases. It may also be advantageous to intentionally shift center and edge positions between the full-set and a sub-set in order to accomplish load balancing to the samplers. The up/dw outputs of an additional set of edge-detectors may drive a selected sub-set of the already present charge-pumps or an additional set of charge-pumps. This principle is not limited to one extra set of edge-detector and is also not limited to a sub-sampling factor of two. For example, in case of a 24-phase oscillator, it would be possible to use sub-sets of 12 (every second sample), 8 (every third sample), 6 (every fourth sample), or 4 (every sixth sample) samples. Using one or more sub-sets is advantageous when a large range of input data rates needs to be supported and the tuning range of the oscillator is limited.

Although it is most convenient to apply single clock samplers, usage of two or more phases per sampler would provide some potentially interesting degrees of freedom:

- Lengthening of the sampling phase and reduction of the reset phase duration to provide more time to the samplers to reach a decision.

- Shortening of the sampler's one-hot output signal assertion periods to obtain shorter feedback pulses thereby obtaining effectively less delay in the feedback loop.

- Shortening of the sampler's one-hot output signal assertion periods to obtain shorter up/down pulses so that more detector outputs can be merged and

Note that in this invention many examples have been given using a multi-phase architecture with 20 phases. A 20-phase architecture has some benefit that it advantageously fits with the 10-bit granularity of the often applied 8B10B coding. However, it should be clear to the skilled reader that the invention can be applied for any even number of phases, 2N, where N corresponds with the number of parallel sampled bits.

Note that for any of the example circuit embodiments, it may sometime be advantageous in practice to apply complementary implementations, or different implementations with similar functionality.

Note that specific choices for logic high or low levels for certain signals in this document are all examples to illustrate the principle, and are not limiting the scope.

Note that although circuit embodiment examples have been shown using CMOS device technology which has well-known advantages for the implementation of logic functions, this invention is not limited to application in CMOS technology, but can also be realized in other technologies, like for example bipolar or BiCMOS.

Note that although this invention is particularly suitable for application in integrated circuits, it may also be applied for systems where the part according to this invention includes multiple components.

It is remarked that the scope of protection of the invention is not restricted to the embodiments described herein. Neither is the scope of protection of the invention restricted by the reference numerals in the claims. The word "comprising" does not exclude other parts than those mentioned in the claims. The word "a(n)" preceding an element does not exclude a plurality of those elements. Means forming part of the invention may both be implemented in the form of dedicated hardware or in the form of a programmed purpose processor. The invention resides in each new feature or combination of features.

## Claims

1.  A multi-phase clock and data recovery circuit system comprising:

    a voltage controlled oscillator including a plurality of identical structural cells coupled in a ring, the voltage controlled oscillator providing a first plurality of phased shifted signals having the same frequency;

    - a feedback loop including:
    - a second plurality of data samplers adapted to receive the first plurality of phase shifted signals provided by the voltage controlled oscillator; and
    - a phase detector coupled to coupled to a phase alignment circuit receiving output signals generated by the second plurality of data samplers and generating control signals to the voltage controlled oscillator at a bit rate of the input signal.

2.  A multi-phase clock and data recovery circuit system as claimed in claim 1, wherein the first plurality of phase shifted signals comprises a first set of signals and a second set of signals, coupled in pairs, each signal of the first set having a corresponded quadrature signal in the second set.

3.  A multi-phase clock and data recovery circuit system of claim 2, wherein the each signal of the first set signals and the second set of signals are inputted to a respective third set of data samplers and a fourth set of data samplers.

4.  A multi-phase clock and data recovery circuit system as claimed in claims 2 or 3, wherein the data samplers comprise one hot data samplers.

5.  A multi-phase clock and data recovery circuit system as claimed in claim 4, wherein the one hot data samplers comprise T latches or T flip-flops generating T-aligned signals.

6.  A multi-phase clock and data recovery circuit system as claimed in any previous claims wherein the phase detector receives a combination of the T-aligned signals.

7.  A method for a multi-phase clock and data recovery circuit comprising steps of;

    - providing a first plurality of phased shifted signals having the same frequency;
    - providing a feedback loop including:
    - a second plurality of data samplers adapted to receive the first plurality of phase shifted signals provided by the voltage controlled oscillator; and
    - a phase detector coupled to coupled to a phase alignment circuit receiving output signals generated by the second plurality of data samplers and generating control signals to the voltage controlled oscillator at a bit rate of the input signal.

FIG. 1

FIG. 2

Align to single-phase clock

| Full-T Latch | Full-T Latch | Full-T Latch | Full-T Latch | Full-T Latch | Full-T Latch | Full-T Latch | Full-T Latch | Full-T Latch | Full-T Latch |

| Data Sampler (frac-T) | Data Sampler (frac-T) | Data Sampler (frac-T) | Data Sampler (frac-T) | Data Sampler (frac-T) | Data Sampler (frac-T) | Data Sampler (frac-T) | Data Sampler (frac-T) | Data Sampler (frac-T) | Data Sampler (frac-T) |

LS  LS  LS  LS  LS  LS  LS  LS  LS  LS

q00 q01 q10 q11 q20 q21 q30 q31 q40 q41
q50 q51 q60 q61 q70 q71 q80 q81 q90 q91

osc freq control

LS  LS  LS  LS  LS  LS  LS  LS  LS  LS

| Data Sampler (frac-T) | Data Sampler (frac-T) | Data Sampler (frac-T) | Data Sampler (frac-T) | Data Sampler (frac-T) | Data Sampler (frac-T) | Data Sampler (frac-T) | Data Sampler (frac-T) | Data Sampler (frac-T) | Data Sampler (frac-T) |

| Full-T Latch | Full-T Latch | Full-T Latch | Full-T Latch | Full-T Latch | Full-T Latch | Full-T Latch | Full-T Latch | Full-T Latch | Full-T Latch |

Align to single-phase clock

# FIG. 3

FIG. 4

FIG. 5

14

data-input
(typically differential)

Data
(Fractional-T)

s##p

s##n

p##
(one of the oscillator clock phases)

Fractional-T sampler with one -hot 'p' and 'n' outputs
- The 'p' output is asserted during the sampling phase when the data-input represents a logic '1' around the sampling moment.
- The 'n' output is asserted during the sampling phase when the data-input represents a logic '0' around the sampling moment.
- None of the outputs is asserted as long as there is no sampler decision. So during a sampling phase either 'p' or 'n' output becomes activated (example: become logical '1'), maybe none of them, but never both.
- During the reset phase of the sampler, both 'p' and 'n' outputs are de-asserted (example: become logical '0').

Tosc

p##

Example of 20 clock phases connected to 20 distributed sampler is triggered to sample by one of the clock phases.

p##

If (data-input @ rising-edge of p## = "1")

s##p

s##n

If (data-input @ rising-edge of p## = "0")

s##p

s##n

# FIG. 6

FIG. 7

FIG. 8

FIG. 9

FIG. 10

# FIG. 11

FIG. 12

A) Example of a single-ended level-shifter implementation

B) Example of a differential level-shifter implementation comprising two single-ended level-shifters according to figure 13a and a shared differential input buffer stage

i=0:N/2-1
k={0,1}
In case of 20-phase achtitecture example
i=0:4
k={0,1}

# FIG. 13

Europäisches
Patentamt

European
Patent Office

Office européen
des brevets

**EUROPEAN SEARCH REPORT**

Application Number

EP 11 19 3713

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2009/074125 A1 (LIN CHIA-LIANG [US]) 19 March 2009 (2009-03-19) * paragraphs [0031] - [0039]; figures 2-4, 6 * ----- | 1-4,7 | INV. H03L7/087 H03L7/091 H03L7/099 |
| X | US 6 026 134 A (DUFFY MICHAEL L [US] ET AL) 15 February 2000 (2000-02-15) * column 3, line 23 - column 9, line 57; figures 1-5 * ----- | 1,2,7 | |
| X | US 5 633 899 A (FIEDLER ALAN [US] ET AL) 27 May 1997 (1997-05-27) * column 5, line 60 - column 8, line 67; figures 5,6 * ----- | 1,7 | |

| | | | TECHNICAL FIELDS SEARCHED (IPC) |
|---|---|---|---|
| | | | H03L |

The present search report has been drawn up for all claims

| Place of search | Date of completion of the search | Examiner |
|---|---|---|
| Munich | 18 May 2012 | Waters, Duncan |

EPO FORM 1503 03.82 (P04C01)

**ANNEX TO THE EUROPEAN SEARCH REPORT
ON EUROPEAN PATENT APPLICATION NO.**

EP 11 19 3713

This annex lists the patent family members relating to the patent documents cited in the above-mentioned European search report.
The members are as contained in the European Patent Office EDP file on
The European Patent Office is in no way liable for these particulars which are merely given for the purpose of information.

18-05-2012

| Patent document cited in search report | | Publication date | Patent family member(s) | | Publication date |
|---|---|---|---|---|---|
| US 2009074125 | A1 | 19-03-2009 | CN 101388665 A<br>TW 200913498 A<br>US 2009074125 A1 | | 18-03-2009<br>16-03-2009<br>19-03-2009 |
| US 6026134 | A | 15-02-2000 | US 6026134 A<br>US 6560306 B1 | | 15-02-2000<br>06-05-2003 |
| US 5633899 | A | 27-05-1997 | JP 10013397 A<br>US 5633899 A | | 16-01-1998<br>27-05-1997 |

EPO FORM P0459

For more details about this annex : see Official Journal of the European Patent Office, No. 12/82